# EUROPEAN PATENT APPLICATION

(11) **EP 2 637 390 A1**
(43) Date of publication of application: **11.09.2013**
(21) Application number: 11865328.6
(22) Date of filing: 29.09.2011
(51) Int. Cl.: H04M 1/60

(54) **METHOD AND DEVICE FOR AUTOMATICALLY ADJUSTING SOUND VOLUME**

(30) Priority: 18.07.2011 CN 201110200452
(71) Applicant: ZTE Corporation, Shenzhen, Guangdong 518057 (CN)
(72) Inventor: JIANG, Chengzhi, Shenzhen Guangdong 518057 (CN)
(74) Representative: South, Nicholas Geoffrey
(86) International application number: PCT/CN2011/080351
(87) International publication number: WO 2012/151839

(57) **Abstract**

The present invention provides a method and a device for automatically adjusting sound volume, wherein the method includes: detecting and acquiring magnitude of a current flowing through a loudspeaker and/or an earphone; quantizing the acquired magnitude of the current to acquire a quantized value of current audio; adjusting sound volume according to a comparison result between the quantized value of the current audio and a audio value which is set by a user. With the present invention, sudden change of sound volume caused by the change of music files or different music types can be effectively avoided, so as to protect hearing of the user and avoid the user from being frightened due to extremely high sound volume, thereby improving user experience.

## Description

### Technical Field

The present invention relates to the field of electrical appliances, and more specifically to a method and a device for automatically adjusting sound volume.

### Background

At present, with the popularization of the 3G network and intelligent terminals, more and more users start to use the intelligent terminals to enjoy recreational activities, for instance: listening to music and watching movies.

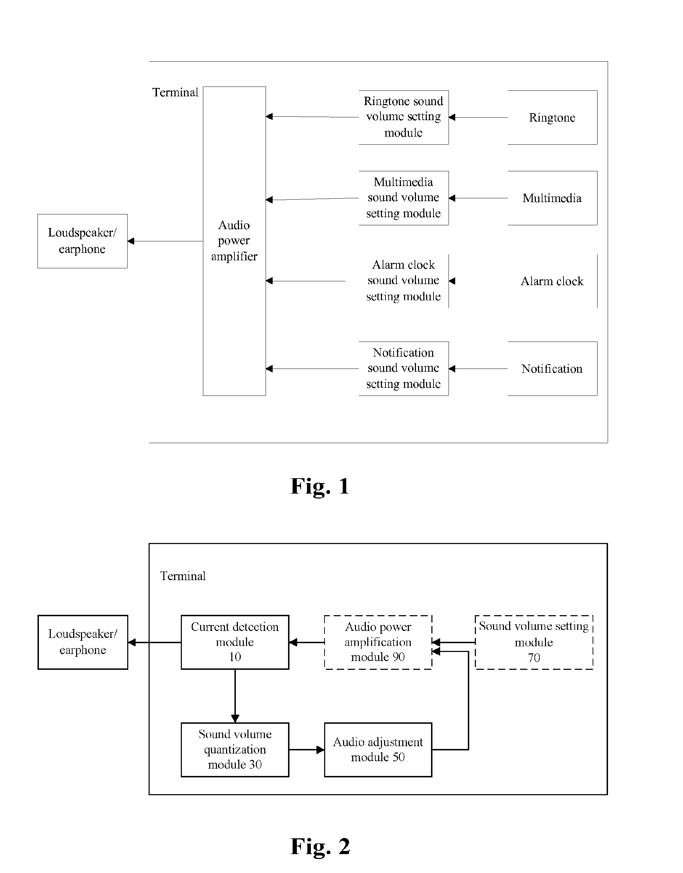

Fig. 1 is a schematic diagram of the structure of a device for adjusting sound volume according to the related art As shown in Fig. 1, a user terminal in the related art includes one or multiple forms of user sound volume adjustment. Since most of users enjoy music and movies with earphones, their hearing will be impaired or they may be frightened by sudden change of sound volume when files are changed or when they suddenly have an incoming call.

In the present market, mainly two kinds of solutions for adjusting sound volume are available, which are described as follows.

The first solution for adjusting sound volume is implemented by adopting a thermistor, and sound volume adjustment is triggered by the change of a resistance value of the thermistor caused by the change of environment.

The second solution for adjusting sound volume is implemented by providing more detailed division for the types of ringtone and sound volume, and more humanized design is achieved by setting sound volume respectively according to different types.

The first solution can not solve the problem to be solved by the present invention. That is because it is absolutely possible that a user operates, e.g. listens to music, in the same environment, in such a case, temperature of the environment does not change, but since audio information of each song is different, automatic adjustment does not work, so the sound volume will still change suddenly

The second solution has obvious difference from the solution. The sound volume can be set only according to different types of ringtone. However, for the music of the same type, the sound volume can not be ensured to be in a proper range. In addition, most of functional machines do not have the function of setting sound volume according to the types.

For the problem in the related art that sudden change of the sound volume caused by different audio files or audio types when music files played by the user are changed or when a call is in during listening to the music may bring discomfort to the user, there is still no effective solution at present.

### Summary

The present invention provides a method and a device for automatically adjusting sound volume to solve the problem in the related art that the sudden change of the sound volume caused by different audio files or audio types when music files played by the user are changed or when a call is in during listening to the music will bring discomfort to the user.

According to one aspect of the present invention, a method for automatically adjusting sound volume is provided.

The method for automatically adjusting sound volume according to the present invention includes: detecting and acquiring magnitude of a current flowing through a loudspeaker and/or an earphone; quantizing the acquired magnitude of the current to acquire a quantized value of current audio; adjusting sound volume according to a comparison result between the quantized value of the current audio and an audio value which is set by a user

Preferably, before detecting and acquiring the magnitude of the current flowing through the loudspeaker and/or the earphone, the method further comprises: receiving setting of a sound volume parameter of a playing terminal performed by a user to acquire the audio value which is set by the user; acquiring a gain parameter of an audio power amplification module corresponding to the sound volume parameter, and outputting audio corresponding to the gain parameter by adjusting an amplification circuit.

Preferably, quantizing the acquired magnitude of the current to acquire the quantized value of the current audio comprises: quantizing an analog quantity of the magnitude of the current; converting a quantization result acquired in a preset period of time to acquire the quantized value of the current audio.

Preferably, before adjusting the sound volume according to the comparison result between the quantized value of the current audio and the audio value which is set by the user, the method further comprises: judging whether the quantized value of the current audio is set by the user by detecting a global quantity and/or a flag bit of the quantized value of the current audio, if the quantized value of the current audio is set by the user, storing the quantized value of the current audio, otherwise starting comparison between the quantized value of the current audio and the audio value which is set by the user

Preferably, adjusting the sound volume according to the comparison result between the quantized value of the current audio and the audio value which is set by the user comprises: judging whether a comparison value between the quantized value of the current audio and the audio value which is set by the user is in a preset range, if the comparison value between the quantized value of the current audio and the audio value which is set by the user exceeds the preset range, adjusting the gain parameter to adjust the sound volume.

According to another aspect of the present invention, a device for automatically adjusting sound volume is provided.

The device for automatically adjusting sound volume comprises: a current detection module, configured to detect and acquire magnitude of a current flowing through a loudspeaker and/or an earphone; a sound volume quantization module, configured to quantize the acquired magnitude of the current to acquire a quantized value of current audio; a sound volume adjustment module, configured to adjust sound volume according to a comparison result between the quantized value of the current audio and an audio value which is set by a user

Preferably, the device further comprises: a sound volume setting module, configured to receive setting of a sound volume parameter of a playing terminal performed by the user to acquire the audio value which is set by the user; an audio power amplification module, configured to acquire a gain parameter corresponding to the sound volume parameter and output audio corresponding to the gain parameter by adjusting an amplification circuit.

Preferably, an audio quantization module comprises: a processing module, configured to quantize an analog quantity of the magnitude of the current; a converting module, configured to convert a quantization result acquired in a preset period of time to acquire the quantized value of the current audio.

Preferably, the device further comprises: a first judgment module, configured to judge whether the quantized value of the current audio is set by the user by detecting a global quantity and/or a flag bit of the quantized value of the current audio; a storage module, configured to store the quantized value of the current audio if the quantized value of the current audio is set by the user, otherwise start comparison between the quantized value of the current audio and the audio value which is set by the user

Preferably, adjusting the sound volume according to the comparison result between the quantized value of the current audio and the audio value which is set by the user comprises: judging whether a comparison value between the quantized value of the current audio and the audio value which is set by the user is in a preset range; adjusting the gain parameter to adjust the sound volume if the comparison value between the quantized value of the current audio and the audio value which is set by the user exceeds the preset range.

The method in the present invention includes: detecting and acquiring the magnitude of the current flowing through the loudspeaker and/or the earphone; quantizing the acquired magnitude of the current to acquire the quantized value of the current audio; adjusting the sound volume according to the comparison result between the quantized value of the current audio and the audio value which is set by the user, which solves the problem in the related art that the sudden change of sound volume caused by different audio files or audio types when music files played by the user are changed or when a call is in during listening to the music may bring discomfort to the user, so as to avoid the sudden change of sound volume caused by the change of music files or different music types, so as to protect the hearing of the user and avoid the user from being frightened due to extremely high sound volume, thereby improving the user experience.

### Brief Description of the Drawings

Fig. 1 is a schematic diagram of the structure of a device for adjusting sound volume according to the related art;
Fig. 2 is a schematic diagram of the structure of a device for automatically adjusting sound volume according to an embodiment of the present invention;
Fig. 3 is a flow chart of a method for automatically adjusting sound volume according to an embodiment of the present invention;
Fig. 4 is a detailed flow chart of a method for automatically adjusting sound volume according to an embodiment of the present invention.

### Detailed Description of the Embodiments

To clarify the technical problem, technical solution and favorable effects to be solved by the present invention, the present invention will be further illustrated in conjunction with the accompanying drawings and embodiments. It shall be understood that the embodiments described herein are only intended to illustrate but not limit the present invention.

The present invention provides a method and a device for automatically adjusting sound volume.

Fig. 2 is a schematic diagram of the structure of the device for automatically adjusting sound volume according to an embodiment of the present invention As shown in Fig. 2, the device for automatically adjusting sound volume according to the embodiment of the present invention includes: a current detection module 10, configured to detect and acquire magnitude of a current flowing through a loudspeaker and/or an earphone; a sound volume quantization module 30, configured to quantize the acquired magnitude of the current to acquire a quantized value of current audio; an audio adjustment module 50, configured to adjust sound volume according to a comparison result between the quantized value of the current audio and an audio value which is set by a user.

In the embodiment of the present invention, the current flowing through the loudspeaker and/or the earphone is detected, current data are quantized and closed loop control is adopted to adjust the sound volume automatically. The solution of the embodiment can effectively avoid the sudden change of the sound volume caused by the change of music files or different music types, thus protecting the hearing of the user, avoiding the user from being frightened due to extremely high sound volume, so as to overcome the problem in the related art that the sound volume can not be automatically adjusted according to setting of the user when the user changes the played music files or plays other music files suddenly eliminate the discomfort brought to the user by the sudden change of the sound volume and make the human body feel comfortable.

Specifically, the current detection module 10, which can be a kind of current detection circuit, measures the current flowing through the circuit of the loudspeaker/earphone at certain intervals and transmits an acquired analog quantity of the current to the sound volume quantization module 30.

The sound volume quantization module 30 is configured to convert the analog quantity to a corresponding value after acquiring the analog quantity transferred from the current detection circuit, wherein the conversion algorithm can be modified according to requirements. The sound volume quantization module 30 generates a quantized value indicating the current sound volume according to a software algorithm after acquiring the quantized values for a period of time (the period of time can be adjusted).

In the embodiment of the application, the device may further include: a sound volume setting module 70, configured to receive setting of a sound volume parameter of a playing terminal performed by a user to acquire the audio value which is set by the user; an audio power amplification module 90, configured to acquire a gain parameter corresponding to the sound volume parameter and output audio corresponding to the gain parameter by adjusting an amplification circuit. In the embodiment, the user sets the playing sound volume, the current flowing through the loudspeaker/earphone can be detected by hardware detection, and the current can be quantized. In this way, when audio files are changed or a call is suddenly in, the quantized value is different from the value set by the user due to the sudden increase or decrease of the current, thus the gain of the audio power amplifier inside the terminal can be adjusted by software so as to achieve the effect of automatic sound volume adjustment.

Specifically, the user sets the current sound volume via a sound volume setting interface of the terminal. The sound volume setting module 70 in the embodiment above acquires the gain parameter of the audio power amplification module 90 corresponding to the sound volume parameter after receiving the sound volume parameter set by the user Subsequently, the gain of an audio power amplification chip is adjusted.

The audio power amplification module 90 may be a hardware chip. After the gain parameter is changed by the sound volume setting module 70, the chip adjusts a hardware amplification circuit to adjust audio output. After the power amplification module completes setting of the gain, the device starts to detect the current in the circuit of the loudspeaker/earphone.

Preferably, the audio quantization module 30 includes: a processing module, configured to quantize an analog quantity of the magnitude of the current; a converting module, configured to convert a quantization result acquired in a preset period of time to acquire the quantized value of the current audio.

The device according to the embodiment of the application may further include: a first judgment module, configured to judge whether the quantized value of the current audio is set by the user by detecting a global quantity and/or a flag bit of the quantized value of the current audio; a storage module, configured to store the quantized value of the current audio if the quantized value of the current audio is set by the user, otherwise start the comparison between the quantized value of the current audio and the audio value which is set by the user

Preferably, the audio adjustment module 50 in the embodiment above may include: a second judgment module, configured to judge whether a comparison value between the quantized value of the current audio and the audio value which is set by the user is in a preset range; an adjustment module, configured to adjust the gain parameter to adjust the sound volume if the comparison value between the quantized value of the current audio and the audio value which is set by the user exceeds the preset range.

Specifically, during specific implementation, after receiving the quantized value transmitted by the sound volume quantization module 30, the audio adjustment module 50 may judge, according to the global quantity, flag bit or other methods, whether the quantized value is set by the user. If the quantized value is set by the user, the quantized value is sent to a sound volume storage module for storage and the setting procedure is completed. If the current quantized value is not caused by the setting of sound volume by the user, the quantized value is compared with the quantized value set by the user and stored currently. If the quantized value is greater than the stored quantized value by a certain range, it indicates that the played file is changed, or there is other ringtone, etc., then the sound volume requires adjustment; therefore, the gain parameter of the power amplification module is adjusted gradually according to the difference between the two quantized values to realize automatic sound volume adjustment.

To sum up, the device for automatically adjusting the sound volume according to the embodiments of the present invention includes the following modules: an audio power amplifier and an earphone or a loudspeaker, further includes: a sound volume setting module 70, a sound volume quantization module 30 and an audio adjustment module 50.

The detailed implementation of the functional modules above is as follows. The user sets the gain of the audio power amplifier by the sound volume setting module 70. A current detection circuit detects the current flowing through the loudspeaker/earphone after the user sets the sound volume. The sound volume quantization module 30 quantizes the current and transmits the quantized value to the audio adjustment module 50. The audio adjustment module 50 judges whether the current quantized value is caused by the setting of sound volume by the user. If the current quantized value is caused by the setting of sound volume by the user, the current quantized value is stored; otherwise, the current quantized value is compared with the quantized value of the sound volume set by the user, and then the gain of the audio power amplifier is set according to the comparison value.

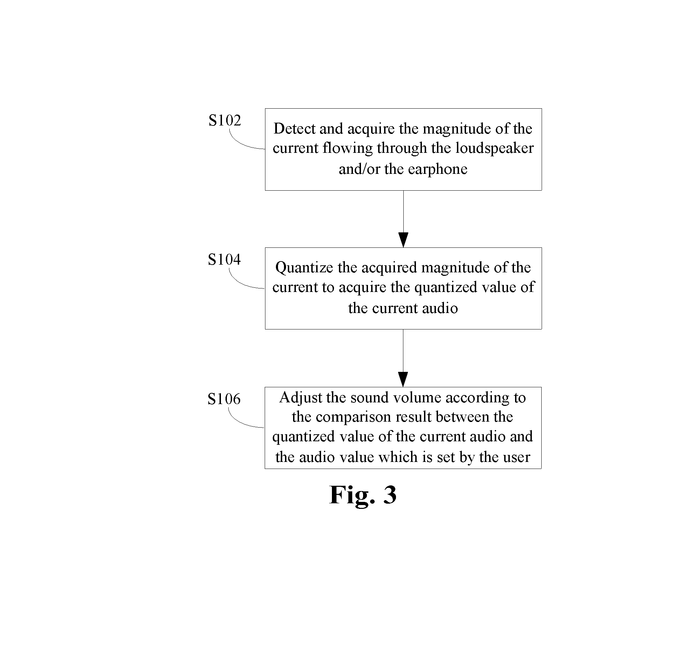

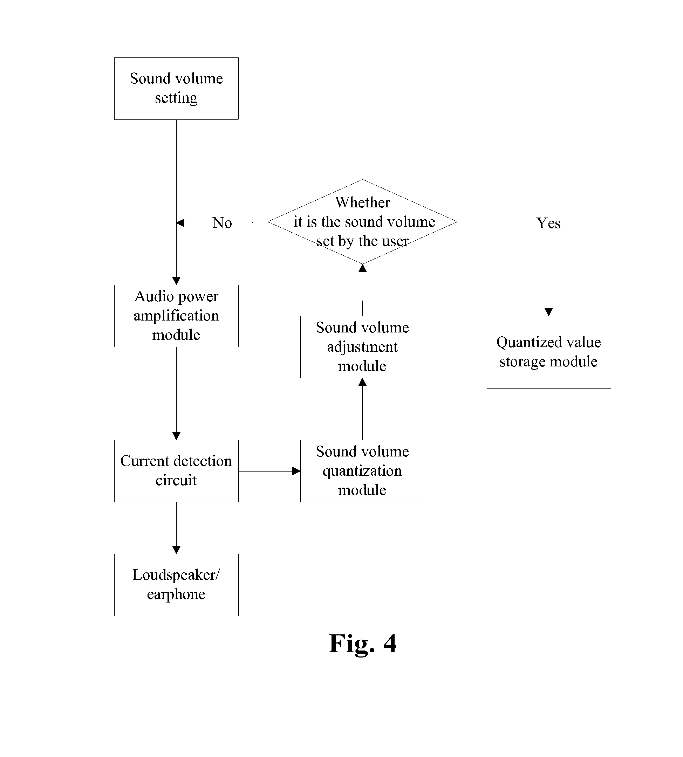

Fig. 3 is a flow chart of a method for automatically adjusting sound volume according to an embodiment of the present invention, Fig. 4 is a detailed flow chart of the method for automatically adjusting sound volume according to an embodiment of the present invention.

As shown in Fig. 3, the method for automatically adjusting sound volume includes the steps below.

Step S102. Magnitude of a current flowing through a loudspeaker and/or an earphone is detected and acquired by the current detection module 10 in Fig. 2.

Step S104. The acquired magnitude of the current is quantized by the sound volume quantization module 30 in Fig. 2 to acquire a quantized value of current audio.

Step S106. The sound volume is adjusted by the audio adjustment module 50 according to the comparison result between the quantized value of the current audio and an audio value which is set by a user.

In the embodiment of the present invention, the magnitude of the current flowing through the loudspeaker/earphone is detected by the current detection module 10, the current value of the current is quantized by the sound volume quantization module 30, the current quantized value is compared with the quantized value set by the user and the sound volume is adjusted based on the judgment. In the embodiment, the current flowing through the loudspeaker/earphone is detected by hardware and the current is quantized. When audio files are changed or a call is suddenly in, the quantized value is different from the value set by the user due to the sudden increase or decrease of the current, thus the gain of an audio power amplifier inside the terminal can be adjusted by software so as to achieve automatic sound volume adjustment.

In the embodiment of the application, as shown in Fig. 4, before detecting and acquiring the magnitude of the current flowing through the loudspeaker and/or earphone by the current detection circuit, the method may further include: setting of a sound volume parameter of a playing terminal performed by a user is received to acquire the audio value which is set by the user; the gain parameter of the audio power amplification module 90 corresponding to the sound volume parameter is acquired by the audio power amplification module and audio corresponding to the gain parameter is output by adjusting the amplification circuit

Preferably, quantizing the acquired magnitude of the current to acquire the quantized value of the current audio includes: an analog quantity of the magnitude of the current is quantized; the quantization result acquired in a preset period of time is converted to acquire the quantized value of the current audio.

In the embodiment of the application, as shown in Fig. 4, before adjusting the sound volume according to the comparison result between the quantized value of the current audio and the audio value which is set by the user, the method may further include: it is judged whether the quantized value of the current audio is set by the user by detecting a global quantity and/or a flag bit of the quantized value of the current audio, if the quantized value of the current audio is set by the user, the quantized value of the current audio is stored, otherwise comparison between the quantized value of the current audio and the audio value which is set by the user is started.

In the embodiment of the application, adjusting the sound volume according to the comparison result between the quantized value of the current audio and the audio value which is set by the user in Step S106 includes: it is judged whether a comparison value between the quantized value of the current audio and the audio value which is set by the user is in a preset range, if the comparison value exceeds the preset range, the gain parameter is adjusted to adjust the sound volume.

It shall be noted that the steps of the embodiment of the present invention shown in the flow charts of the figures can be carried out, such as, in a group of computer systems of which the computers are capable of executing instructions. In addition, although the flow chart shows the logical sequence, in some cases, the steps shown or described herein can be carried out in other sequences.

From the description of the embodiments above, it can be concluded that the embodiments of present invention realize the following technical effects: the current flowing through the loudspeaker and/or earphone is detected, current data are quantized and closed loop control is adopted to adjust the sound volume, which can effectively avoid the sudden change of sound volume caused by the change of music files or different types of music, so as to protect the hearing of the user and avoid the user from being frightened due to extremely high sound volume, thereby improving user experience.

Obviously, those skilled in the art shall understand that the above-mentioned modules and steps of the present invention can be realized by using general purpose calculating device, can be integrated in one calculating device or distributed on a network which consists of a plurality of calculating devices. Alternatively, the modules and the steps of the present invention can be realized by using the executable program code of the calculating device. Consequently, they can be stored in the storing device and executed by the calculating device, or they are made into integrated circuit module respectively or a plurality of modules or steps thereof are made into one integrated circuit module. In this way, the present invention is not restricted to any particular hardware and software combination.

The description above presents preferred embodiments of the present invention, but as mentioned previously, it shall be understood that the present invention is not limited to the form disclosed in the context without excluding other embodiments. It can be used in various other combinations, modifications and environment, and can be modified with the instructions above or the technology or knowledge of the related field within the concept scope of the present invention described in the article. Any modification or change without deviating from the principle and scope of the present invention made by those skilled in the art shall be in the protection scope of the Claims of the present invention.

## Claims

1. A method for automatically adjusting sound volume, **characterized by** comprising:
detecting and acquiring magnitude of a current flowing through a loudspeaker and/or an earphone;
quantizing the acquired magnitude of the current to acquire a quantized value of current audio;
adjusting sound volume according to a comparison result between the quantized value of the current audio and an audio value which is set by a user

2. The method as claimed in Claim 1, **characterized in that** before detecting and acquiring the magnitude of the current flowing through the loudspeaker and/or the earphone, the method further comprises:
receiving setting of a sound volume parameter of a playing terminal performed by a user to acquire the audio value which is set by the user;
acquiring a gain parameter of an audio power amplification module corresponding to the sound volume parameter, and outputting audio corresponding to the gain parameter by adjusting an amplification circuit

3. The method as claimed in Claim 2, **characterized in that** quantizing the acquired magnitude of the current to acquire the quantized value of the current audio comprises:
quantizing an analog quantity of the magnitude of the current;
converting a quantization result acquired in a preset period of time to acquire the quantized value of the current audio.

4. The method as claimed in Claim 3, **characterized in that** before adjusting the sound volume according to the comparison result between the quantized value of the current audio and the audio value which is set by the user, the method further comprises:
judging whether the quantized value of the current audio is set by the user by detecting a global quantity and/or a flag bit of the quantized value of the current audio, if the quantized value of the current audio is set by the user, storing the quantized value of the current audio, otherwise starting comparison between the quantized value of the current audio and the audio value which is set by the user

5. The method as claimed in Claim 4, **characterized in that** adjusting the sound volume according to the comparison result between the quantized value of the current audio and the audio value which is set by the user comprises:
judging whether a comparison value between the quantized value of the current audio and the audio value which is set by the user is in a preset range, if the comparison value between the quantized value of the current audio and the audio value which is set by the user exceeds the preset range, adjusting the gain parameter to adjust the sound volume.

6. A device for automatically adjusting sound volume, **characterized by** comprising:
a current detection module, configured to detect and acquire magnitude of a current flowing through a loudspeaker and/or an earphone;
a sound volume quantization module, configured to quantize the acquired magnitude of the current to acquire a quantized value of current audio;
a sound volume adjustment module, configured to adjust sound volume according to a comparison result between the quantized value of the current audio and an audio value which is set by a user.

7. . The device as claimed Claim 6, **characterized by** further comprising:
a sound volume setting module, configured to receive setting of a sound volume parameter of a playing terminal performed by the user to acquire the audio value which is set by the user;
an audio power amplification module, configured to acquire a gain parameter corresponding to the sound volume parameter and output audio corresponding to the gain parameter by adjusting an amplification circuit

8. . The device as claimed Claim 6, **characterized in that** an audio quantization module comprises:
a processing module, configured to quantize an analog quantity of the magnitude of the current;
a converting module, configured to convert a quantization result acquired in a preset period of time to acquire the quantized value of the current audio.

9. . The device as claimed Claim 6, **characterized by** further comprising:
a first judgment module, configured to judge whether the quantized value of the current audio is set by the user by detecting a global quantity and/or a flag bit of the quantized value of the current audio;
a storage module, configured to store the quantized value of the current audio if the quantized value of the current audio is set by the user, otherwise start comparison between the quantized value of the current audio and the audio value which is set by the user.

10. The device as claimed Claim 6, **characterized in that** the sound volume adjustment module comprises:
a second judgment module, configured to judge whether a comparison value between the quantized value of the current audio and the audio value which is set by the user is in a preset range;
an adjustment module, configured to adjust the gain parameter to adjust the sound volume if the comparison value between the quantized value of the current audio and the audio value which is set by the user exceeds the preset range.
